# EUROPEAN PATENT SPECIFICATION

(11) **EP 0 450 329 B1**
(45) Date of publication and mention of the grant of the patent: **09.07.1997**
(21) Application number: 91103346.2
(22) Date of filing: 06.03.1991
(51) Int. Cl.: H05K 13/04, B23K 1/015

(54) **Localized soldering station**
Örtlich begrenzte Lötstation
Station à souder localisée

(30) Priority: 02.04.1990 US 503320
(43) Date of publication of application: 09.10.1991
(73) Proprietor: International Business Machines Corporation, Armonk, N.Y. 10504 (US)
(72) Inventor: Glovatsky, Andrew Zachary, Johnson City, New York 13907 (US); Lynch, Robert John, Endicott, N.Y.13760 (US); Motter, James George, Jr., Owego, N.Y 13827 (US); Repchak, Steve Andrew, Endicott, N.Y. 13760 (US); Vittone, Jean Marie, Apalachin, N.Y. 13732 (US); Yetter, Lawrence Robert, Apalachin, N.Y. 13732 (US)
(74) Representative: Rach, Werner, Dr.

(56) References cited:
- EP-A- 0 205 309
- EP-A- 0 326 539
- WO-A-90/03103
- US-A- 4 762 264
- IBM TECHNICAL DISCLOSURE BULLETIN vol. 13, no. 3, August 1970, NEW YORK,US DINGMAN, E.G. "solvent vapor solder reflow"

## Description

The present invention, generally, relates to apparatus for removing, replacing and attaching electronic components that are soldered in place on a printed wire board or substrate and, more particularly, to apparatus constructed to use a state changing medium having predetermined characteristics.

Typical rework stations available today to remove and to replace surface mounted components on a printed wire board or substrate are constructed to use (1) hot gas, (2) soldering tweezers, (3) hot plate (or hot belt) and (4) lasers. Rework stations using hot gas are the most popular. However, there are major problems with using hot gas, which include very high gas temperature to attain necessary thermal transfer, difficulty in controlling the time/temperature and difficulty in applying a hot gas selectively to only a component to be removed. Damage to a printed wire board or substrate is not uncommon, and with a densely packed surface mounted components and multiple layer printed wire boards today, the cost of such finished modules can easily run into many thousands of dollars.

In today's technology, a substrate includes much more than just a "printed circuit". It is a highly complex product of manufacture that includes interconnecting circuitry for miniaturized packages of electronic components fabricated as individual units, called "integrated circuits", which include usually a large number of solid state devices.

For dense packaging, it is the practice today to use printed wire boards bonded by adhesives to opposite sides of a metallic heat sink. Such structures increase exponentially the problems encountered when it becomes necessary to repair or to replace an integrated circuit component package, such as a leadless chip carrier, without damage to the other components or to the printed wire board.

The idea of using a boiling solvent in some way to facilitate removal and resolder of electronic components was suggested by E.G. Dingman. See IBM Technical Disclosure Bulletin Volume 13, No. 3 dated August, 1970.

United States patent No. 4,561,586 to Abel et al. issued some 15 years later describing a method of removing an integrated circuit package soldered to a printed circuit board by flowing a heated liquid over the package.

United States patent No. 4,762,264 to Peck describes a structure using a preheat portion before passing a board with a surface mounted component through a reflow temperature portion.

United States patent No. 4,799,617 to Friedman describes a heated gas system for removing surface mounted assemblies from a work piece.

United States patent No. 4,828,162 to Donner et al. describes a structure using heated jaws for gripping and removing an integrated circuit while leaving other components undisturbed.

Notwithstanding the noble efforts of these specialized structural arrangements to overcome the several disadvantages that are inherent in a hot gas system of component removal, industry returns repeatedly to the hot gas system, only because it remains, until the present invention, the most practical means to accomplish the task.

A solder station according to WO 90/03103 uses hot gases at the work location. The applied high temperatures are capable of destroying components.

Therefore still the problem of the invention is to remove the selected component from a substrate without disturbing other components and adjacent pans

The problem is solved by a localized soldering station as characterized in claim 1. The appending depending claims describe further advantageous improvements of the invention.

The invention meets also advantageously the following objects:

It is a principal object of the present invention to provide a new and improved structural arrangement for a localized soldering station that is both practical and effective in accomplishing the removal and/or mounting of selected components

It is also an object of the invention to provide a localized soldering station that uses a state changing medium for component removal selectively from a printed wire board or substrate.

Another object of the invention is to provide a localized soldering station that is adapted for the use of a localized vapor phase technique in the repair of surface mounted components.

Still another object of the invention is to provide a system for removing and for replacing leadless chip packages that are attached by soldered connections on a printed wire board or substrate without damage to other components.

Yet another object of the invention is to provide a localized soldering station to use the principle of vapor phase reflow to effect attachment of components to a printed wire board or a substrate.

Briefly, a rework station that is constructed and arranged in accordance with the principles of the present invention includes means for containing a supply of a medium that is capable of changing from a first state to a second state, the temperature of the medium in its second state being predetermined, and it also includes means for applying heat to the medium in its first state in order for the medium to transpose into its second state. A work location is provided whereby an electronic circuit module is supported in a predetermined position for the application of the medium in its second state.

These and other objects, features and advantages of the invention will become more readily apparent from the following detailed description of the presently preferred embodiment, taken in conjunction with the accompanying drawings.
- FIG. 1: is a view in perspective of a rework station that is constructed and arranged in accordance with the invention with some of the internal features illustrated in broken lines.
- FIG. 2: is a side view in elevation of a rework station that is constructed and arranged in accordance with the invention illustrating further features of the invention.
- FIG. 3: is a view from the rear of the rework station of the invention illustrating a modification.

None of the hot gas rework stations available commercially today admit of the features which are obtained by means of the present invention, i.e., that utilize the principle of vapor phase reflow and preselecting a medium according to its temperature of vaporization, which is fixed, stable and known (for a preselected medium). The temperature is fixed in that all fluid mediums vaporize at a temperature that is substantially predictable, and it is stable in that as long as a particular fluid medium boils, its vapor temperature remains constant over a relatively wide range of higher heat applied to its liquid state. Thus, energy can be transferred by vapor and can be made to relinquish its heat through changing back to a liquid upon condensing.

To ensure an unambiguous understanding of the vapor phase reflow principle as it is used in the invention and its difference from the hot gas principle, the following definitions should be established firmly:
- fluid -: a substance tending to flow or conform in its shape to the outline of its container.
- liquid -: a substance between solid and gaseous states.
- gas -: a substance without independent shape or form.
- vapor -: a substance in the gaseous state, not liquid or solid.
- state -: a condition of being for a substance.

As used in this description, a substance that changes its state is a fluid that, when heated, changes to a vapor at a known, relatively fixed temperature. It is important for the present invention that, when a medium changes its state, it occurs at a known, relatively definite and fixed, predictable temperature.

The temperature at which a fluid changes its state, i.e., at which it vaporizes, is different for various substances, and therefore, it is important to select a substance that changes its state at a temperature at, or just above, the temperature at which the solder used to attach a component will melt. For the present illustrative embodiment of the invention, an electronic liquid available commercially under the trade name Fluorinert FC5311 is entirely effective. The names "Fluorinert" and "FC" are trademarks of 3M Company. This particular fluid vaporizes at precisely 215° C, and since solder melts at a temperature of 180-200° C, depending upon its composition, this liquid has been found to be entirely effective.

Before describing in detail the structural form of the rework station of the present invention, early tests were conducted using the Fluorinert FC5311 liquid in this manner in order to prove satisfactory operation of the vapor phase reflow principle with this particular liquid. The Fluorinert FC5311 liquid was put in a flask and heated to its boiling point with a heating mantle. The resulting vapor was transported through a 1/4 inch stainless steel tube covered with a heating tape to maintain the temperature above 215° C (such as, approximately 240° C) to prevent condensation of the vapor.

The end of the stainless steel tube was fitted with a quartz nozzle formed to match the shape of the component to be removed and formed to a size to fit over the component and the joints of solder by which it was connected. By this means, vapor was applied directly to the component, and as it changed its state back to a liquid, it flowed over the component and the solder connections, causing the solder connections to melt. The component was removed easily by lifting it from its place. Any appropriate means can be used to lift the component, such as tweezers or a vacuum pen with a miniature nozzle.

Since the liquid Fluorinert FC5311 is expensive, the substrate with the component to be removed was held over a shallow pan in order to collect the liquid as it condensed, and since the heat of vaporization, the desired 215° C, was the highest temperature that was obtained, excessively high temperatures were avoided. Also, since the solder joints are readily visible through the clear, quartz nozzle, the lifting of the component can be timed to coincide with the melting of all connections depending upon the printed wire board thermal mass. Due to the carefully sized and dimensioned quartz nozzle, the heating and the resulting reflow is typically 30 to 90 seconds and localized to the component to be removed.

Accordingly, a structure in accordance with the invention is illustrated in the drawings, where the same or similar parts are identified by the same reference numeral in the several Figures.

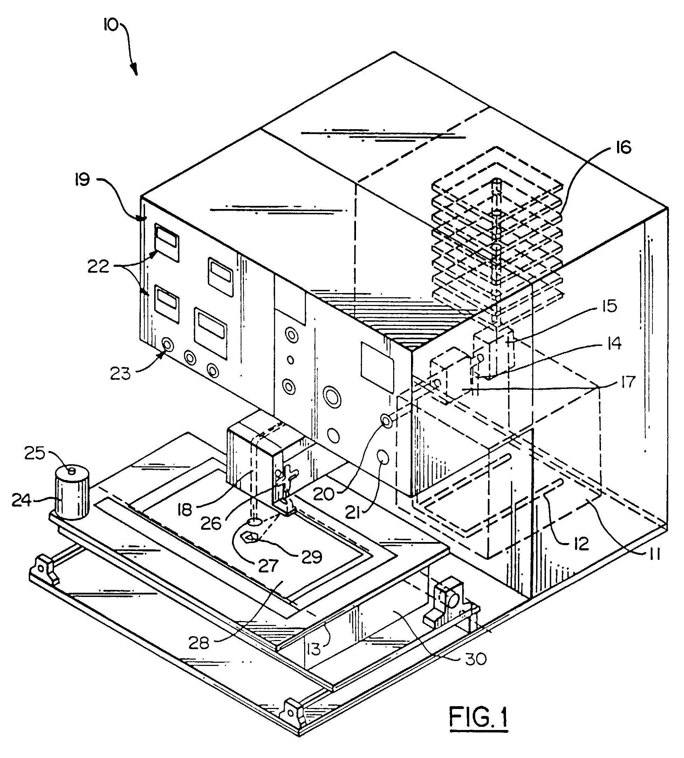

Referring now more particularly to FIG. 1, the overall rework station of the invention is identified by the reference numeral 10. A stainless steel container 11 is located within the rework station 10 to form a reservoir for a fluid selected for the value of its heat of vaporization. To heat the fluid within the container 11, cartridge heating rods are identified by the numeral 12.

A work location 13 is formed to support an electronic circuit module with a component to be removed or attached, and vapor from the container 11 is carried up through a conduit 14. So that the rework station 10 is always in a condition of readiness to operate and to prevent the development of excessive pressure by the vapor within the container 11, the conduit 14 is connected to a normally open valve 15 to convey the vapor upwardly, past a plurality of cooling fins 16.

By this means, as the vapor rises, it is cooled by the fins 16, and upon cooling, its state changes back to a liquid. By gravity, the liquid now returns to the container 11 for reuse, and since such liquid is expensive, its being vented to atmosphere and being lost is avoided.

However, with a printed wire board or substrate positioned at the work location 13, as will be described in detail presently, the rework station 10 of the invention is ready for operation by merely opening a valve 17 and closing the valve 15 which diverts the vapor from the container 11 to the work location 13 through the valve 17 and through a conduit 18.

Now, in accordance with the presently preferred embodiment, the rework station 10 is operated principally from a front panel 19. For example, by opening and closing a switch 20 on the panel 19 or by a foot switch (not shown), the cartridge heating rods 12 in the container 11 are controlled and made to increase energy to the liquid in the container 11 as needed. An indication of its "on" or "off" status is shown by an indicator lamp 21.

A plurality of temperature indicators/controllers are located on the front panel 19 and are identified by the numeral 22. Any number of electrical switches 23 are located on the front panel 19, depending upon the number of functions to be controlled from the panel.

For example, in the presently preferred embodiment of the invention, a power "on", a power "off" and an "off-on" toggle switch for the vapor transfer conduit are located on the front panel 19. The temperature indicators 22 for the preferred form of the invention are digital, but clearly, this can be varied according to individual preference, if desired.

To describe the work location 13 now in more detail, a handle 24 is positioned at the left front corner of the work location 13 with a thumb actuated brake release button 25. Upon grasping the handle 24 and pressing the brake release button 25, the entire work location 13 can be moved in the x-y plane.

An adjustment in the vertical direction is obtained by rotating a knob 26 to move a quartz nozzle 27 toward and away from a printed wire board or substrate 28. In other words, the work location 13, with its support of the substrate 28, is moveable freely only in the x-y plane, with the brake release button 25 depressed.

An aiming light 29 shines on the component to be removed as an aid in proper positioning of the substrate 28 in the x-y plane. Due to the extremely small dimensions involved, the aiming light 29 is an important feature, and clearly also, it can be as simple or as elaborate as desired or as needed for a particular use.

Another important feature is illustrated by the collection tray 30 that is positioned beneath the substrate 28 to collect run off. When vapor is directed into contact with a component to be removed from the substrate 28, and the vapor condenses around the solder connection transferring its latent heat to the solder, the vapor returns to its first, or liquid, state. It now flows along the upper surface of the printed wire board or substrate 28, over its edges and is collected in the pan 30 for reuse.

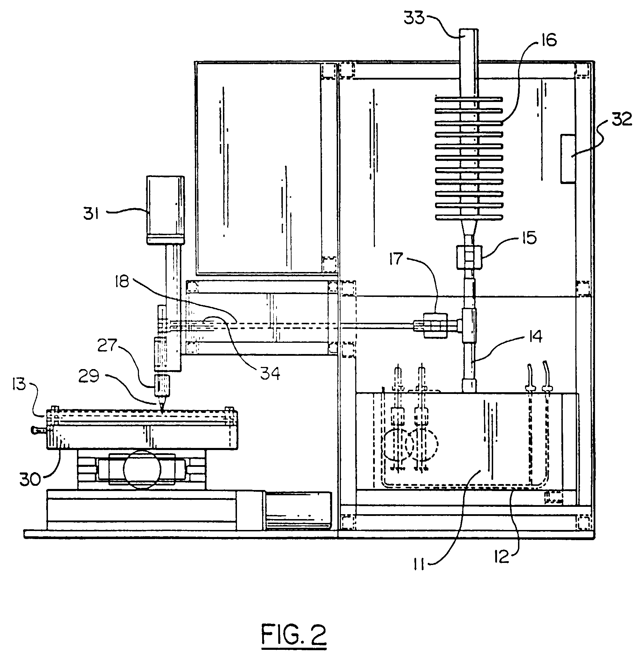

FIG. 2 of the drawings illustrates better several of the features of a structure in accordance with the invention. For example, the conduit 14 connects heated liquid in its second, or vapor, state straight up through the valve 15 into the cooling fins 16, so that, when the latent heat in the vapor is extracted by the cooling fins 16 returning the vapor to its first, or liquid, state, the liquid falls by gravity back through the vapor, extracting further latent heat from the vapor and increasing the efficiency of this portion of the rework station.

Also in FIG. 2 of the drawings, for positioning the work location 13 and to move the nozzle vertically, instead of the knob 26 as shown in FIG. 1, a computer including the x-y table with z-arm motion, identified by the single reference numeral 31, from the Despensing System, Model LD1000A, (from Automation Unlimited, Inc.) was used successfully here.

It is an important aspect of the invention that the latent heat of the vapor that is being delivered to the quartz nozzle 27 be maintained because otherwise the vapor will condense back to its fluid state. To maintain this temperature, a heating tape is wrapped around the conduit 18, and the heat provided by this arrangement is maintained by the controller 22.

Heat is applied initially to the fluid while it is in the container 11, as described previously in connection with the arrangement of FIG. 1, by the cartridge heating rods 12 to its boiling point, whereupon it changes its state to a second, or vapor, state. The valve 15 being open when the rework station is not in use and the arrangement of the cooling fins 16, permit the rework station of the invention to be in a condition of readiness.

However, while in a busy environment, the condition of constant readiness is a highly desirable characteristic. This poses a situation of potential danger to damage to the localized soldering station should the fluid within the container 11 become depleted.

Therefore, in this modification of the localized soldering station, the temperature of the fluid in the container 11 is monitored constantly by thermal couples connected to visual displays 22. A liquid level sensor provides external monitoring of the liquid by lights and an audible alarm for positive monitoring.

In an environment where the ambient temperature may be too high for convection cooling by the fins 16 alone, a cooling fan 32 is positioned within the same general area as the fins 16 for additional cooling.

Even though the fluid selected to be heated within the container 11 may not be toxic or its vapor otherwise harmful, it is preferred that the upper end 33 of the conduit 14 be connected directly to an exhaust open to the atmosphere externally of the immediate area where the rework station 10 is located.

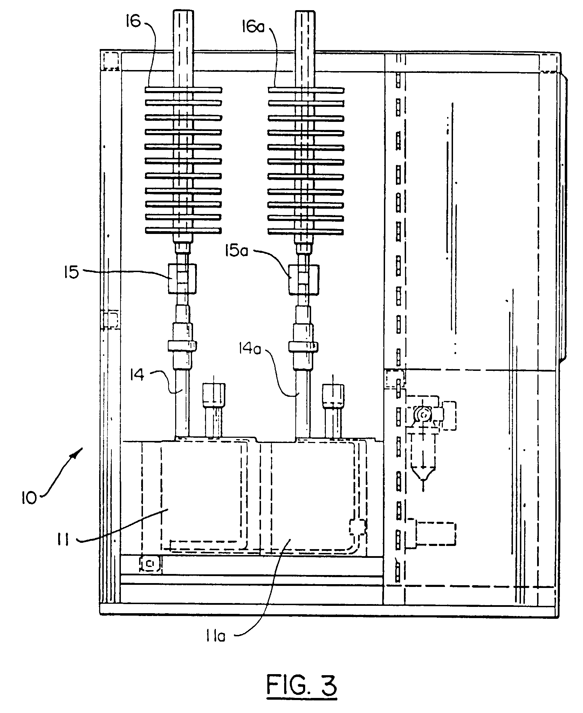

FIG. 3 of the drawings illustrates a further modification of the invention. As viewed from the rear, the rework station 10 of the present invention is adaptable for ready use with solders of different melting points, or with adhesives that require elevated temperatures to melt. Multiple containers 11 and 11a are located adjacent one another with vapor conduits 14 and 14a extending side-by-side to similar two-way valves 15 and 15a.

During an interval of non-use, such as a "stand-by" condition, different fluids within the containers 11 and 11a would be boiling and developing vapors. Such vapors are vented upwardly through open valves 15 and 15a and cooled by fins 16 and 16a. Upon changing states, from vapor to fluid, the fluid returns to its respective container, as described previously hereinabove.

In Operation. Assume that during the final manufacturing examination, a component on a substrate is identified as needing replacement. A fluid is selected for use in the rework station 10 of the invention depending upon the composition of the particular solder used during manufacture to attach the component to the printed wire board or substrate.

It is the composition of the solder that determines its melting or reflow temperature. A popular and often used solder today melts at approximately 200° C. For this solder, the fluid selected is perfluorophenanthrene (available commercially from 3M as "Fluorinert FC5311"), which boils at 215° C.

The Fluorinert fluid is added to the container 11, and the cartridge heating rods 12 are turned "on". It has been found to take approximately 30 minutes to achieve boiling for approximately two gallons of the fluid, and during this interval, the valve 15 is "open" to avoid excessive build up of vapor pressure in the rework station.

A quartz nozzle is selected to fit closely over the component to be removed, and the selected nozzle is attached to the localized soldering station, as identified by the reference numeral 27 in FIG. 1 of the drawings. Being formed of quartz material, the nozzle 27 permits an operator to view the condition of the solder as the process develops, and when all of the solder connections are melted, the component is lifted from the printed wire board or substrate by any suitable means, such as tweezers, a vacuum pencil, etc.

While the fluid in the container is being heated, an electronic circuit module is positioned on the work location 13 and is adjusted to be directly below the nozzle 27, by grasping the handle 24, depressing the thumb actuated brake release button 25 and moving the work location 13 about until a proper position is achieved. The locating light 29 is helpful in achieving the proper location.

The quartz nozzle 27 is lowered over the component to be removed by turning the knob 26. Now, when the valve 15 is closed and the valve 17 is opened, vapor moves through the steel conduit 18, while being maintained at its temperature by a heating tape 34, FIG. 2, about the conduit 18, to the nozzle 27.

Energy is supplied by the cartridge heating rods 12 to the fluid while the foot switch is activated; thus, generating a constant supply of vapor during reflow.

Upon contacting the surface of the component to be removed and the solder connections holding it in place, the vapor loses its latent heat of vaporization and changes back to its fluid state. The fluid is collected in the pan 30 and returned to the container 11.

The heat transfer from the vapor to the solder connections, since it is localized, continues until all of the solder is melted, which condition will be clearly visible through the quartz nozzle. After a component is removed, a replacement may be soldered in its place by repeating the above described steps.

## Claims

1. A localized soldering station for removing, replacing and attaching electronic circuit components that are soldered in place on a printed wire board (28), comprising:
a container (11) for a supply of a medium,
means (12,34) to apply heat to said medium,
a work location (13) including means to support an electronic circuit module (28) in a predetermined position, and
means (14, 17, 18,27) to convey said supply of said medium to said rework location (13), characterized in
that the means (12, 34) to apply heat are adapted to a medium that changes from a first state to a second state, at a predetermined temperature, this second state being a vapor state, whereby the medium changes from said vapor state to a liquid state upon contact with a predetermined part of an electronic circuit module (28);
that said means (14, 17, 18, 27) to convey are adapted to convey said supply of said medium in said second state;
a nozzle (27) at said work location (13) is provided to confine said vapor to said predetermined part of the electronic circuit module (28);
and means (30) are provided to collect that medium in liquid state after flowing over said part for return to said container (11).

2. A localized soldering station as defined by claim 1 wherein said medium is perfluorophenanthrene.

3. A localized soldering station as defined by claim 1 or 2 wherein said means (12, 34) to apply heat is adaptable to apply heat at a first temperature, to maintain said medium at its boiling temperature, and to apply heat at a second temperature to generate said supply of said medium in its second state.

4. A localized soldering station as defined by anyone of the claims 1 to 3 wherein said means for containing said supply of said medium includes a stainless steel metal container (11), and means to convey said medium in said second state includes stainless steel conduit means (14, 18).

5. A localized soldering station as defined by anyone of the claims 1 to 4 wherein said means (14, 18) to convey said supply of said medium in said second state includes heating means (34) to maintain said temperature of said second state of said medium.

6. A localized soldering station as defined by anyone of the claims 1 to 5 including conduit means (14, 18) to convey said medium in said second state from said means (11) for containing, and means (14, 15, 16) for venting said medium in said second state when not in use at said work location (13).

7. A localized soldering station as defined by claim 6 including means (14, 15, 16) to recirculate said medium in said second state back to said means (11, 12) to apply heat when not being conveyed to said work location (13).

8. A localized soldering station as defined by anyone of the claims 1 to 7 including stainless steel conduit means (14, 18) to convey said medium in said second state to said work location (13), heating means (34) connected with said conduit means (14, 18) to maintain said medium in said second state, and first valve means (17) with said conduit means (14, 18) to ontrol the conveyance of said medium in said second state.

9. A localized soldering station as defined by anyone of the claims 1 to 8 including said first valve means (17) connected with said means (14, 18) to convey for interrupting a conveyance, second valve means (15) to vent said medium when said conveyance is interrupted and means (16) connected with said second valve means (15) to cool said interrupted medium.

10. A localized soldering station as defined by claim 9 including valve means (15) in a conduit (14) from said supply of a medium to connect said medium in said second state with cooling fins (16) for recirculating said medium back to said supply.

11. A localized soldering station as defined by anyone of the claims 1 to 10 including a plurality of means (11, 11a) for containing supplies of different medium with different predetermined temperatures at which said second state is developed, and each of said means for containing supplies being connected with separate cooling means (16, 16a).

12. A localized soldering station as defined by anyone of the claims 1 to 11 wherein said predetermined temperature of said second state of said medium is 215° C, and said means to convey includes means (12, 34) to provide approximately 240° C to maintain said medium in said second state.

## Patentansprüche

1. Eine örtlich begrenzte Lötstation zum Entfernen, Ersetzen und Anbringen von Komponenten für elektronische Schaltungen, die auf eine Schaltkarte (28) gelötet werden, folgendes umfassend:
einen Behälter (11) zur Aufnahme eines Lötmediums,
Mittel (12, 34), um dem genannten Medium Wärme zuzuführen,
eine Bearbeitungsstation (13) mit Mitteln zum Abstützen eines elektronischen Schaltungsmoduls (28) in einer vorbestimmten Position, und
Mittel (14, 17, 18, 27), um das genannte Medium der genannten Bearbeitungsstation (13) zuzuführen, dadurch gekennzeichnet,
dass die Mittel (12, 34) zum Zuführen von Wärme an ein Medium angepasst sind, das seinen Zustand bei einer vorbestimmten Temperatur von einem ersten Zustand in einen zweiten Zustand verändert, wobei dieser zweite Zustand ein Dampfzustand ist, wodurch das Medium bei Kontakt mit einem vorbestimmten Teil eines elektronischen Schaltungsmoduls (28) seinen Zustand von dem genannten Dampfzustand in einen flüssigen Zustand verändert;
dass die genannten Mittel (14, 17, 18, 27) für die Zuführung des genannten Mediums so ausgeführt sind, dass sie das genannte Medium in dem genannten zweiten Zustand zuführen;
eine Düse (27) an der genannten Bearbeitungsstation (13) vorgesehen ist, die den genannten Dampf auf den genannten vorbestimmten Teil des elektronischen Schaltungsmoduls (28) begrenzt;
und Mittel (30) vorgesehen sind, die das genannte Medium im flüssigen Zustand aufnehmen, nachdem es über den genannten Teil geflossen ist, und es in den genannten Behälter (11) zurückführen.

2. Eine örtlich begrenzte Lötstation nach Anspruch 1, bei der das genannte Medium Perfluorphenanthren ist.

3. Eine örtlich begrenzte Lötstation nach Anspruch 1 oder 2, bei der das genannte Mittel (12, 34) für die Wärmezuführung so angepasst werden kann, dass es Wärme mit einer ersten Temperatur zuführt, um das genannte Medium auf seiner Siedetemperatur zu halten, und Wärme mit einer zweiten Temperatur zuführt, um das genannte Zuführen des genannten Mediums in seinem zweiten Zustand zu bewirken.

4. Eine örtlich begrenzte Lötstation nach einem jeden der Ansprüche 1 bis 3, bei der das genannte Mittel für die Aufnahme des genannten Mediums einen Behälter aus rostfreiem Stahl (11) umfasst und ein Mittel für die Zuführung des genannten Mediums in dem genannten zweiten Zustand Leitungen aus rostfreiem Stahl (14, 18) umfasst.

5. Eine örtlich begrenzte Lötstation nach einem jeden der Ansprüche 1 bis 4, bei der die genannten Mittel (14, 18) für die Zuführung des genannten Mediums in dem genannten zweiten Zustand ein Aufheizmittel (34) umfassen, um die genannte Temperatur des genannten zweiten Zustands des genannten Mediums aufrechtzuerhalten.

6. Eine örtlich begrenzte Lötstation nach einem jeden der Ansprüche 1 bis 5 mit Leitungen (14, 18) für die Zuführung des genannten Mediums in dem genannten zweiten Zustand von dem genannten Aufnahmebehälter (11) und Mittel (14, 15, 16), um das genannte Medium in dem genannten zweiten Zustand abzulassen, wenn es an der genannten Bearbeitungsstation (13) nicht gebraucht wird.

7. Eine örtlich begrenzte Lötstation nach Anspruch 6 mit Mitteln (14, 15, 16), die das genannte Medium in dem genannten zweiten Zustand zu den genannten Mitteln (11, 12) für die Zuführung von Wärme zurückführen, um Wärme zuzuführen, wenn es nicht der genannten Bearbeitungsstation (13) zugeführt wird.

8. Eine örtlich begrenzte Lötstation nach einem jeden der Ansprüche 1 bis 7 mit Leitungen aus rostfreiem Stahl (14, 18), um das genannte Medium in dem genannten zweiten Zustand zu der genannten Bearbeitungsstation (13) zu führen, Aufheizmittel (34), die an die genannten Leitungen (14, 18) angeschlossen sind, und die das genannte Medium in dem genannten zweiten Zustand halten, und ein erstes Ventil an den genannten Leitungen (14, 18), welches die Leitung des genannten Mediums in dem genannten zweiten Zustand steuert.

9. Eine örtlich begrenzte Lötstation nach einem jeden der Ansprüche 1 bis 8, das genannte erste Ventil (17) umfassend, welches an die genannten Leitungen (14, 18) angeschlossen ist, zum Unterbrechen einer Weiterleitung, ein zweites Ventil (15) zum Ablassen des genannten Mediums, wenn die genannte Weiterleitung unterbrochen ist, und Mittel (16), die mit dem genannten zweiten Ventil (15) verbunden sind und das genannte, nicht weitergeleitete Medium abkühlen.

10. Eine örtlich begrenzte Lötstation nach Anspruch 9 mit einem Ventil (15) in einer Leitung (14) von dem genannten Aufnahmebehälter, um das genannte Medium in dem genannten zweiten Zustand mit Kühlrippen (16) zu verbinden, über die das genannte Medium in den genannten Behälter zurückgeführt wird.

11. Eine örtlich begrenzte Lötstation nach einem jeden der Ansprüche 1 bis 10 mit einer Vielzahl von Mitteln (11, 11a), welche verschiedene Medien mit unterschiedlichen vorher festgelegten Temperaturen enthalten, an denen sich der genannte zweite Zustand entwickelt, wobei jeder der genannten Behälter mit getrennten Kühlvorrichtungen (16, 16a) verbunden ist.

12. Eine örtlich begrenzte Lötstation nach einem jeden der Ansprüche 1 bis 11, bei der die genannte vorbestimmte Temperatur des genannten zweiten Zustands des genannten Mediums 215°C beträgt und das genannte Mittel zum Weiterleiten ein Mittel (12, 34) umfasst, das etwa 240°C bereitstellt, um das genannte Medium in dem genannten zweiten Zustand zu halten.

## Revendications

1. Poste de soudure localisé pour enlever, remplacer et fixer des composants de circuit électronique qui sont soudés en place sur une carte de câblage imprimé (28), comprenant :
un récipient (11) servant à conserver un milieu,
un moyen (12, 33) pour appliquer la chaleur audit milieu,
un emplacement de travail (13) comprenant un moyen pour supporter un module de circuit électronique (28) dans une position prédéterminée et
un moyen (14, 17, 18, 27) pour transporter ladite alimentation dudit milieu vers ledit emplacement de travail (13), caractérisé en ce que les moyens (12, 34) pour appliquer la chaleur sont adaptés à un milieu qui change d'un premier état à un second état à une température prédéterminée, ce second état étant un état vaporisé, dans lequel le milieu change de l'état de vapeur à un état liquide sur contact avec une partie prédéterminée d'un module de circuit électronique (28) ;
en ce que lesdits moyens (14, 17, 18, 27) pour le transport sont adaptés pour transporter ladite alimentation dans ledit second état ;
une buse (27) audit emplacement de travail (13) est prévue pour confiner ladite vapeur à ladite partie prédéterminée du module de circuit électronique (28) ;
des moyens (30) sont prévus pour collecter ce milieu à l'état liquide après circulation sur ladite partie pour retour audit récipient (11).

2. Poste de soudure localisé selon la revendication 1, dans lequel ledit milieu est du perfluorophénanthrène.

3. Poste de soudure localisé selon la revendication 1 ou 2, dans lequel lesdits moyens (12, 34) pour appliquer la chaleur est adaptable pour appliquer la chaleur à une première température afin de maintenir ledit milieu à sa température d'ébullition et pour appliquer la chaleur à une seconde température afin de générer ladite alimentation dudit milieu dans son dit second état.

4. Poste de soudure localisé selon l'une quelconque des revendications 1 à 3, dans lequel ledit moyen pour contenir ladite alimentation dudit milieu comprend un récipient en acier inoxydable (11) et un moyen pour transporter ledit milieu dans ledit second état comprend un moyen de conduit en acier inoxydable (14, 18).

5. Poste de soudure localisé selon l'une quelconque des revendications 1 à 4, dans lequel ledit moyen (14, 18) pour transporter ladite alimentation dudit milieu dans ledit second état comprend un moyen de chauffage (34) pour maintenir ladite température dudit second état dudit milieu.

6. Poste de soudure localisé selon l'une quelconque des revendications 1 à 5, comprenant un moyen de conduit (14, 18) pour transporter ledit milieu dans ledit second état à partir dudit moyen (11) pour le contenir, et un moyen (14, 15, 16) pour purger ledit milieu dans ledit second état lorsqu'il n'est pas en utilisation audit emplacement de travail (13).

7. Poste de soudure localisé selon la revendication 6, comprenant des moyens (14, 15, 16) pour faire recirculer ledit milieu dans ledit second état vers ledit moyen (11, 12) pour appliquer la chaleur lorsqu'il n'est pas transporté audit emplacement de travail (13).

8. Poste de soudure localisé selon l'une quelconque des revendications 1 à 7, comprenant un moyen de conduit en acier inoxydable (14, 18) pour transporter ledit milieu dans ledit second état audit emplacement de travail (13), un moyen de chauffage (34) raccordé audit moyen de conduit (14, 18) afin de maintenir ledit milieu dans ledit second état et un premier moyen de soupape (17) avec ledit moyen de conduit (14, 18) pour contrôler le transport dudit milieu dans ledit second état.

9. Poste de soudure localisé selon l'une quelconque des revendications 1 à 8, comprenant ledit premier moyen de soupape (17) raccordé audit moyen (14, 18) pour le transport pour interrompre un transport, un second moyen de soupape (15) pour purger ledit milieu lorsque ledit transport est interrompu et un moyen (16) raccordé audit second moyen de soupape (15) pour refroidir ledit milieu interrompu.

10. Poste de soudure localisé selon la revendication 9, comprenant un moyen de soupape (15) dans un conduit (14) à partir de ladite alimentation du milieu pour connecter ledit milieu dans ledit second état avec des ailettes de refroidissement (16)pour faire recirculer ledit milieu vers ladite alimentation.

11. Poste de soudure localisé selon l'une quelconque des revendications 1 à 10, comprenant une pluralité de moyens (11, 11a) pour contenir des alimentations de milieux différents avec des températures prédéterminées différentes auxquelles ledit second état est développé et chacun desdits moyens pour contenir les alimentations étant raccordé à des moyens de refroidissement séparés (16, 16a).

12. Poste de soudure localisé selon l'une quelconque des revendications 1 à 11, dans lequel ladite température prédéterminée dudit second état dudit milieu est de 215°C et ledit moyen pour le transport comprend un moyen (12, 34) pour le placer à approximativement 240°C afin de maintenir ledit milieu dans ledit second état.
